# EUROPÄISCHE PATENTANMELDUNG

(11) **EP 1 274 129 A2**
(43) Veröffentlichungstag der Anmeldung: **08.01.2003**
(21) Anmeldenummer: 02012596.9
(22) Anmeldetag: 06.06.2002
(51) Int. Cl.: H01L 25/11

(54) **Elektronische Anordnung und zugehöriges Verfahren**

(30) Priorität: 04.07.2001 DE 10132455
(71) Anmelder: ROBERT BOSCH GMBH, 70442 Stuttgart (DE)
(72) Erfinder: Gademann, Lothar, 72108 Rottenburg (DE); Vetter, Guenter, 72820 Sonnenb-hl (DE); Jacob, Wolfgang, 72160 Horb (DE)

(57) **Zusammenfassung**

Es wird eine elektrische Anordnung und ein Verfahren zur Herstellung einer elektrischen Anordnung mit einem Bauelement (10) vorgeschlagen, wobei das Bauelement mit einem Kühlkörper (20) verbunden ist, wobei das Bauelement (10) in den Kühlkörper (20) eingeschrumpft ist, wobei das Bauelement elektrisch vom Kühlkörper isoliert ist.

## Beschreibung

### Stand der Technik

Es sind Brückengleichrichterschaltungen bekannt, bei denen zwei Kommutierungsgruppen dadurch gebildet werden, dass beispielsweise drei Leistungshalbleiterbauelemente auf einem Kühlkörper zusammengefasst werden, so dass zwei Kommutierungsgruppen die Brückenschaltungsanordnung bilden und wobei die Kühlkörper der jeweiligen Kommutierungsgruppen elektrisch voneinander isoliert sind.

### Vorteile der Erfindung

Die erfindungsgemäße elektrische Anordnung und das Verfahren hat demgegenüber den Vorteil, dass Leistungshalbleiterbauelemente auf einem Kühlkörper vorgesehen sind, wobei die mit dem Kühlkörper verbundenen Teile der Leistungshalbleiterbauelemente unterschiedliche elektrische Polarität aufweisen können, so dass der Kühlkörper elektrisch voneinander zu isolierende Teile von Leistungshalbleiterbauelementen kühlt und dass es gleichzeitig möglich ist, dass Leistungshalbleiterbauelemente auf einem Kühlkörper untergebracht sind, obwohl sie unterschiedliche Polarität aufweisen. Hierdurch müssen Kommutierungsgruppen nicht auf beispielsweise zwei verschiedenen Kühlkörpern untergebracht werden, die gegeneinander elektrisch isoliert vorgesehen sind und wobei die Isolierschichten zwischen den als Kommutierungsgruppen vorgesehenen Kühlkörpern die Wärmeabfuhr von den Halbleiterbauelementen begrenzen und so wegen der beschränkten zulässigen maximalen Temperatur des pn-Übergangs (Junction Temperatur) eine größere Leistung der Halbleiterbauelemente erforderlich macht.

Durch die in den Unteransprüchen aufgeführten Maßnahmen sind vorteilhafte Weiterbildungen und Verbesserungen der im Hauptanspruch angegebenen elektrischen Anordnung möglich.

### Zeichnung

Ein Ausführungsbeispiel der Erfindung ist in der Zeichnung dargestellt und in der nachfolgenden Beschreibung näher erläutert. Es zeigen
Figur 1 ein Halbleiterbauelement, das mit einem Kühlkörper verbunden ist, in Seitenansicht und in Draufsicht,
Figur 2 das Gehäuse eines zweipoligen erfindungsgemäßen Halbleiterbauelements, im Beispiel eine Diode,
Figur 3 das Gehäuse eines dreipoligen Halbleiterbauelements, im Beispiel ein Transistor,
Figur 4 eine Gleichrichterbrückenschaltung und
Figur 5 in Draufsicht, Seitenansicht und Unteransicht ein Realisierungsbeispiel der Gleichrichterbrückenschaltung gemäß der Erfindung.

### Beschreibung des Ausführungsbeispiels

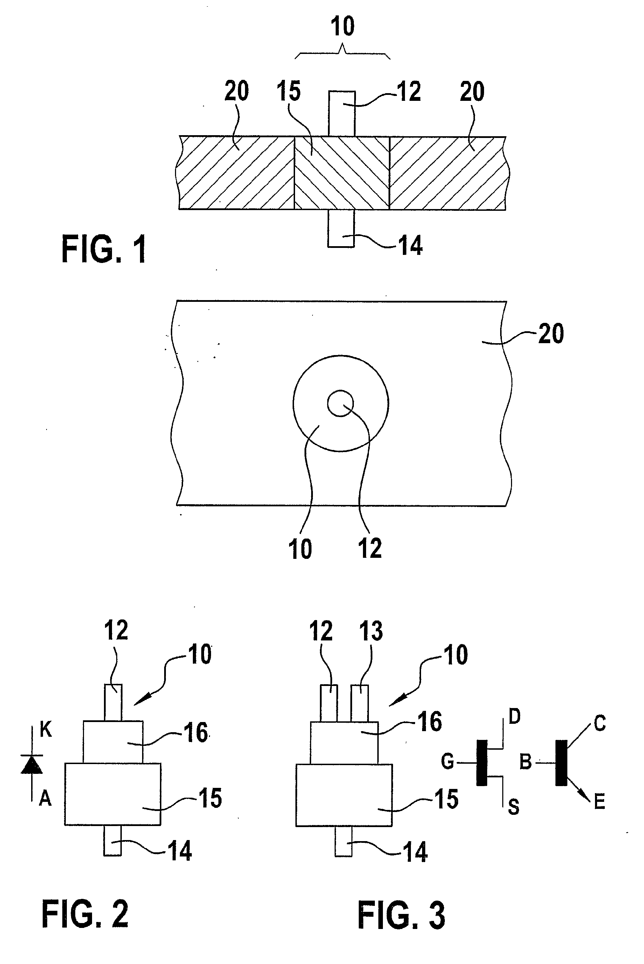

In Figur 1 ist ein Halbleiterbauelement 10, welches im Folgenden auch einfach Bauelement 10 genannt wird, dargestellt, welches mit einem Kühlkörper 20 verbunden ist. Das Bauelement 10 ist insbesondere als Leistungshalbleiterbauelement vorgesehen, d.h. das Bauelement 10 umfasst einen Leistungshalbleiter. Das Bauelement 10 umfasst einen ersten Anschluß 12 und einen zweiten Anschluß 14, wobei der zweite Anschluß 14 elektrisch mit einem Sockel 15 verbunden ist, über den das Bauelement 10 mit dem Kühlkörper 20 verbunden ist. Der Sockel 15 hat im Wesentlichen eine zylindrische oder kegelförmige Mantelfläche, welche mit einer Bohrung (ohne Bezugszeichen) im Kühlkörper 20 zusammenwirkt, so dass eine mechanische Verbindung zwischen dem Kühlkörper 20 und dem Bauelement 10 herstellbar ist. Im oberen Teil der Figur 1 ist eine Seitenansicht der Anordnung von Bauelement 10 und Kühlkörper 20 dargestellt, währenddem im unteren Teil der Figur 1 eine Draufsicht von Kühlkörper 20 und Bauelement 10 dargestellt ist.

In Figur 2 ist das Bauelement 10 anhand des Beispiels eines zweipoligen Bauelements 10 dargestellt, im Beispiel eine Diode, welche im linken Teil der Figur 2 als Schaltsymbol mit einem mit dem Bezugszeichen A versehenden Anschluß, der die Anode repräsentiert, und mit einem mit dem Bezugszeichen K versehenen Anschluß, der die Kathode repräsentiert, versehen ist. Dargestellt ist wiederum der Sockel 15 des Bauelements 10, welcher wiederum die Verbindung mit dem in Figur 2 nicht dargestellten Kühlkörper 20 sicherstellt, weiterhin ein Gehäuse 16 des Bauelements 10, welches im Wesentlichen oberhalb des Sockels 15 mit einem im Wesentlichen geringeren Durchmesser vorgesehen ist. Oberhalb des Gehäuses 16 ragt der erste. Anschluß 12 aus dem Bauelement 10 bzw. aus dem Gehäuse 16 des Bauelements 10 heraus. Der erste Anschluß 12 ist insbesondere bei einer Diode als Kopfdraht vorgesehen. Der Sockel, aus dem im unteren Teil der zweite Anschluß 14 herausführt, ist mit dem zweiten Anschluß 14 elektrisch leitend verbunden.

In Figur 3 ist das Bauelement anhand des Beispiels eines erfindungsgemäßen dreipoligen Bauelements 10 dargestellt, wobei im rechten Teil der Figur 3 Beispiele für Schaltsymbole solcher dreipoliger Bauelemente, insbesondere. Transistoren, dargestellt sind. Zum einen handelt es sich dabei um einen MOS-Leistungstransistor, welcher ein mit dem Bezugszeichen S (Source) bezeichneten Anschluß, einen mit dem Bezugszeichen D (Drain) bezeichneten Anschluß und einen mit dem Bezugszeichen G (Gate) bezeichneten Anschluß aufweist. Rechts daneben ist die symbolhafte Darstellung eines Bipolartransistors dargestellt, welcher einen mit dem Bezugszeichen E (Emitter) dargestellten Anschluß, einen mit dem Bezugszeichen C (Kollektor) versehenden Anschluß und einen mit dem Bezugszeichen B (Basis) versehenen Anschluß aufweist. Im linken Teil der Figur 3 ist wiederum das Bauelement 10 in zu Figur 2 analoger Weise dargestellt, wobei gleiche Bezugszeichen gleichen Teilen des Bauelements 10 entsprechen, wobei jedoch im Unterschied zu Figur 2 aus dem Gehäuse 16 nicht ein einziger erster Anschluß 12 sondern noch ein dritter Anschluß 13 herausgeführt ist, so dass die drei Anschlüsse des dreipoligen Bauelements berücksichtigt sind.

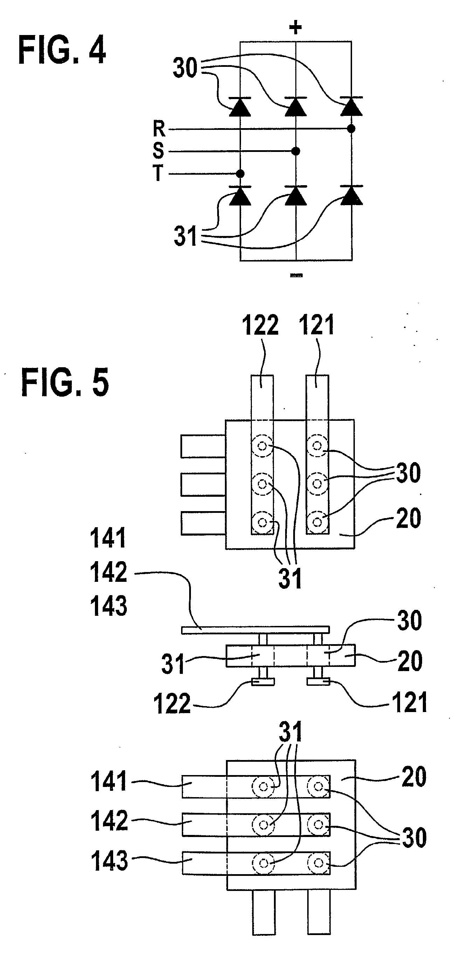

In Figur 4 ist eine Gleichrichterschaltung als Beispiel einer erfindungsgemäßen elektrischen Anordnung dargestellt. Die Gleichrichteranordnung gemäß Figur 4 umfasst insgesamt sechs Leistungshalbleiterdioden als Beispiele von Bauelementen 10. Drei erste Dioden, die mit dem Bezugszeichen 30 versehen sind, sind jeweils mit ihrer Anode an drei, mit dem Bezugszeichen R, S und T versehenden Eingangsanschlüssen verbunden und mit ihrer Kathode mit einem mit einem Pluszeichen versehenen Ausgang der elektrischen Anordnung verbunden. Drei weitere zweite Dioden, die mit dem Bezugszeichen 31 versehen sind, sind mit den Eingängen R, S, T jeweils über ihren Kathodenanschluß verbunden und bilden mit ihrem Anodenanschluß gemeinsam die mit einem Minuszeichen versehene Ausgangsanschlußleitung der elektrischen Anordnung. An den mit Plus- bzw. Minuszeichen versehenen Ausgangsleitungen der elektrischen Anordnung ist eine pulsierende, jedoch gleichgerichtete Spannung abgreifbar, falls an den Eingängen R, S, T eine Drehstromspannung anliegt.

Die physische Realisierung einer Gleichrichterschaltung gemäß der Figur 4 ist in Figur 5 dargestellt. Im oberen Teil der Figur 5 ist eine Ansicht von unten der elektrischen Anordnung dargestellt, im mittleren Bereich ist eine Seitenansicht der elektrischen Anordnung dargestellt und im unteren Teil der Figur 5 ist eine Draufsicht der elektrischen Anordnung dargestellt. In der Draufsicht ist der Kühlkörper 20 dargestellt, mit dem die ersten Dioden 30 und die zweiten Dioden 31 verbunden sind. An den nicht dargestellten zweiten Anschlüssen 14 der Dioden 30, 31, die als Beispiel für allgemeine Bauelemente 10 dienen, sind eine erste Eingangsschiene 141, eine zweite Eingangsschiene 142 und eine dritte Eingangsschiene 143 angeschlossen, über welche die drei Schaltungseingänge, die in Figur 4 mit den Bezugszeichen R, S, T bezeichnet sind, realisiert sind. In der Seitenansicht ist wiederum der Kühlkörper 20, die ersten Dioden 30, die zweiten Dioden 31 und die Eingangsschienen 141, 142, 143 dargestellt. Weiterhin ist in der Seitenansicht eine erste Stromausgangsschiene 121 und eine zweite Stromausgangsschiene 122 dargestellt, welche den Ausgängen der in Figur 4 dargestellten Gleichrichterschaltung entsprechen. Eine der beiden Stromausgangsschienen 121, 122 entspricht der positiven Ausgangsleitung (in Figur 4 mit einem Pluszeichen versehen) und die andere der beiden Stromausgangsschienen 121, 122 entspricht dem negativen Ausgang (mit einem Minuszeichen versehen) der Figur 4. In der Seitenansicht der Figur 5 ist erkennbar, dass die erste Stromausgangsschiene 121 mit den zweiten Anschlüssen 14 der ersten Dioden 30 verbunden ist und dass die zweite Stromausgangsschiene 122 mit den zweiten Anschlüssen 14 der zweiten Dioden 31 verbunden ist. Die zweiten Anschlüsse der Dioden 30, 31 sind jedoch in Figur 5 nicht dargestellt.

In der Sicht von unten, die im oberen Teil der Figur 5 dargestellt ist, sind wiederum die Stromausgangsschienen 121, 122, die ersten und zweiten Dioden 30, 31 sowie der Kühlkörper 20 dargestellt.

Der Kühlkörper 20 ist von den Dioden 30, 31 bzw. allgemein von einem beliebigen erfindungsgemäßen Bauelement 10, isoliert vorgesehen. Dies wird erfindungsgemäß dadurch erreicht, dass eine Isolierschicht zwischen dem Kühlkörper 20 und dem Bauelement 10 vorgesehen ist. Die Isolierschicht ist beispielsweise in Form einer Eloxalschicht auf dem Kühlkörper 20, der in diesem Fall beispielsweise aus Aluminium hergestellt ist, oder in Form einer Lackierung des Kühlkörpers 20 mit zum Beispiel herkömmlichem Drahtlack vorgesehen. Weiterhin ist es erfindungsgemäß vorgesehen, anstelle oder zusätzlich zur Eloxierung und/oder der Lackierung eine Beschichtung des Kühlkörpers 20 mittels einer keramischen und/oder einer Pulverbeschichtung vorzusehen.

Der Kühlkörper 20 ist mit sechs Bohrungen für die Aufnahme der Dioden 30, 31 bzw. allgemein für die Aufnahme von erfindungsgemäßen Bauelementen 10 versehen. Die oben angesprochene Eloxalschicht wird beispielsweise bei einem Kühlkörper 20 aus Aluminium nach der mechanischen Bearbeitung, d.h. der Erzeugung der Bohrungen, aufgebracht. Das Kühlkörpermaterial und die Toleranz der Bohrungen sind dem Material und dem Durchmesser der Sockel 15 der Bauelemente 10 so anzupassen, dass eine genügende Pressung der Sockel 15 der Bauelemente 10 im vorgesehenen Temperaturbereich gewährleistet ist. Für Niederspannungsanwendungen, beispielsweise kleiner als 80V bietet eine Eloxalschicht eine ausreichende Durchschlagfefstigkeit zwischen dem Kühlkörper 20 und dem Sockel 15 der Bauelemente 10. Bei Einsatz der erfindungsgemäßen elektrischen Anordnung für höhere Spannungen wird die Durchschlagfestigkeit durch eine zusätzliche Lackierung des Kühlkörpers 20 mit herkömmlichem Drahtlack erhöht. Um die Isolationsschicht zwischen dem Sockel 15 des Bauelements 10 und dem Kühlkörper 20 bei dem Fügevorgang der Bauelemente 10 nicht zu beschädigen, werden die Sockel der Bauelemente 10 nicht in den Kühlkörper 20 eingepresst, sondern kraftfrei eingeschrumpft. Hierzu werden die Bauelemente 10 auf zum Beispiel ca. -40°C abgekühlt und in den auf zum Beispiel ca. 175°C aufgeheizten Kühlkörper 20 eingesetzt. Eine solche Verbindung zwischen den Bauelementen 10 und dem Kühlkörper 20 ist auch nach dem Einschrumpfen der Bauelemente 10 noch betriebssicher, d.h. die Bauelemente 10 können aus dem Kühlkörper 20 nicht "herausfallen", da die Bauelemente 10 im späteren Betrieb infolge ihrer Eigenerwärmung immer heisser als der Kühlkörper 20 sind, d.h. eine höhere Temperatur als der Kühlkörper 20 aufweisen.

Erfindungsgemäß ist es natürlich ebenso vorgesehen, entweder zusätzlich oder alternativ zur Passivierung des Kühlkörpers eine Passivierung des Bauelements 10 - insbesondere seines Sockels 15 - vorzusehen. Eine solche Passivierung des Bauelements 10 ist beispielsweise mittels den oben angegebenen Verfahren wie Eloxierung und/oder Lackierung und/oder Beschichtung vorgesehen.

Erfindungsgemäß ist es so, dass ein als Diode gemäß Figur 2 vorgesehenes Bauelement 10 sowohl derart vorgesehen sein kann, dass die Kathode am ersten Anschluß 12 und die Anode am zweiten Anschluß 14 vorgesehen ist, als auch derart vorgesehen sein, dass die Anode am ersten Anschluß 12 und die Kathode am zweiten Anschluß 14 vorgesehen ist. Dies ist insofern von einer gewissen Relevanz, als die Dioden 30, 31 bei der in Figur 5 dargestellten Anordnung erfindungsgemäß in der Regel derart in den Kühlkörper 20 eingebracht sind, dass das Gehäuse 16 bzw. der erste Anschluß 12 auf der gleichen Seite des Kühlkörpers 20 vorgesehen ist. Da auf der gleichen Seite des Kühlkörpers 20 sowohl die erste als auch die zweite Stromausgangsschiene vorgesehen ist, müssen die ersten Dioden 30 umgekehrt angeschlossen sein als die zweiten Dioden 31, d.h. der erste und zweite Anschluß 12, 14 bei den ersten Dioden 30 und den zweiten Dioden 31 müssen vertauscht sein.

Die Verbindung der ersten und zweiten Anschlüsse 12, 14 der Bauelemente 10, aber auch des dritten Anschlusses 13 der Bauelemente 10 mit den Stromausgangsschienen 121, 122 bzw. den Stromeingangsschienen 141, 142, 143 erfolgt mit den bekannten Techniken, d.h. Löten, Schweissen, Krimpen (radiales Festquetschen einer Hülse auf einem Stift) oder dergleichen.

Erfindungsgemäß ist ebensor vorgesehen, ein Bauelement mit einem Kühlkörper zu verbinden, wobei das Bauelement elektrische Anschlüsse nur an einer Seite des Bauelements 10 aufweist.

## Patentansprüche

1. Elektrische Anordnung für wenigstens ein Bauelement (10), das einen Leistungshalbleiter umfasst, wobei das Bauelement (10) mit einem Kühlkörper (20) verbunden ist und wobei das Bauelement (10) in den Kühlkörper (20) eingeschrumpft vorgesehen ist.

2. Anordnung nach Anspruch 1, **dadurch gekennzeichnet, dass** das Bauelement (10) vom Kühlkörper (20) elektrisch getrennt ist.

3. Anordnung nach Anspruch 1 oder 2, **dadurch gekennzeichnet, dass** die Oberfläche des Kühlkörpers (20), insbesondere im Bereich der Verbindung mit dem Bauelement (10), und/oder dass die Oberfläche des Sockels (15) des Bauelements (10), insbesondere im Bereich der Verbindung mit dem Kühlkörper, elektrisch passiviert vorgesehen ist.

4. Anordnung nach Anspruch 3, **dadurch gekennzeichnet, dass** die Oberfläche des Kühlkörpers (20) und/oder des Sockels (15) des Bauelements (10) eloxiert vorgesehen ist und/oder mit einer Lackschicht versehen und/oder mit einer Beschichtung versehen vorgesehen ist.

5. Anordnung nach einem der Ansprüche 1 bis 4, **dadurch gekennzeichnet, dass** die Anordnung als Brückenanordnung mit einer Mehrzahl von in dem Kühlkörper (20) integrierten Bauelemente (10) vorgesehen ist.

6. Verfahren zur Herstellung einer elektrischen Anordnung mit einem Bauelement (10), das einen Leistungshalbleiter umfasst, wobei die Anordnung weiterhin einen Kühlkörper (20) aufweist, wobei das Bauelement (10) in den Kühlkörper (20) eingeschrumpft wird.
